# EUROPÄISCHE PATENTSCHRIFT

(11) **EP 3 031 308 B1**
(45) Veröffentlichungstag und Bekanntmachung des Hinweises auf die Patenterteilung: **13.10.2021**
(21) Anmeldenummer: 14747950.5
(22) Anmeldetag: 07.08.2014
(51) Int. Cl.: H05K 3/20, H05K 3/34, H05K 1/11

(54) **LEITERPLATTENANORDNUNG, STEUERVORRICHTUNG FÜR EIN KÜHLERLÜFTERMODUL UND VERFAHREN**
CIRCUIT BOARD ASSEMBLY, CONTROL DEVICE FOR A COOLER FAN MODULE AND METHOD
STRUCTURE DE CIRCUIT IMPRIMÉ, DISPOSITIF DE COMMANDE D'UN MODULE DE VENTILATEUR DE RADIATEUR ET PROCÉDÉ

(30) Priorität: 07.08.2013 DE 102013215588
(43) Veröffentlichungstag der Anmeldung: 15.06.2016
(73) Patentinhaber: Brose Fahrzeugteile SE & Co. Kommanditgesellschaft, Würzburg, 97076 Würzburg (DE)
(72) Erfinder: EHRMANN, Steffen, 97239 Aub (DE); ZICK, Stefan, 97332 Volkach (DE)
(74) Vertreter: Isarpatent
(86) Internationale Anmeldenummer: PCT/EP2014/066962
(87) Internationale Veröffentlichungsnummer: WO 2015/018881

(56) Entgegenhaltungen:
- EP-A2- 0 908 943
- WO-A1-90/04912
- DE-A1- 19 912 443
- DE-A1-102008 013 226
- US-A- 3 457 639
- US-A- 4 913 285
- US-A- 5 421 081
- US-A1- 2001 045 777
- US-A1- 2003 174 477
- US-A1- 2003 174 477
- US-A1- 2004 190 272
- US-A1- 2005 263 318
- US-A1- 2007 001 297

## Beschreibung

### GEBIET DER ERFINDUNG

Die vorliegende Erfindung betrifft eine Leiterplattenanordnung. Die vorliegende Erfindung betrifft ferner eine Steuervorrichtung für ein Kühlerlüftermodul eines Kraftfahrzeuges und ein Verfahren zur Montage eines Leistungshalbleiterbauelementes auf einer Leiterplatte.

### TECHNISCHER HINTERGRUND

Eine Leiterplatte, die häufig auch als Platine oder PCB (Printed Circuit Board) bezeichnet wird, ist einen Träger für elektrische und elektronische Bauteile. Sie dient der mechanischen Befestigung und elektrischen Verbindung elektrischer und elektronischer Schaltungskomponenten. Auf Leiterplatten können neben mehr oder weniger komplexen analogen und digitalen integrierten Schaltungen auch diskrete Bauelemente angeordnet sein, wie z. B. Leistungs(halbleiter)bauelemente. Leistungshalbleiterbauelemente sind in der Leistungselektronik für das Steuern und Schalten hoher elektrischer Ströme und/oder Spannungen ausgelegt.

Eine Voraussetzung für einen zuverlässigen Betrieb dieser Leistungshalbleiterbauelemente ist die Abführung der im Betrieb entstehenden Wärme. Die erzeugte thermische Energie wird meist an einen im Gehäuse des Leistungshalbleiterbauelementes vorgesehenen Kühlkörper geführt, der die Energie über die Außenseite des Gehäuses an die Umgebung abgibt. Wesentlich für die Kühlung ist, dass eine thermische Kopplung dieses Kühlkörpers mit der Leiterplatte oder einen auf der Leiterplatte vorgesehenen Kühlkörper vorhanden ist. Wird erzeugte thermische Energie nicht effektiv abgeführt, so kann dies auf der Leiterplatte und im Bauteil zu einem Wärmestau führen. Als Folge können die verwendeten Leistungshalbleiterbauelemente unerwünscht schnell degradieren, was zur Funktionsbeeinträchtigung oder zum Ausfall des Leistungshalbleiterbauelements führen kann.

Bei Verwendung solcher Stanzgitter als Kühlkörper zur Abführung der erzeugten thermischen Energie können Leistungshalbleiterbauelemente mit ihren Außenanschlüssen direkt auf dem Stanzgitter aufgelötet werden. Dabei übernimmt das Stanzgitter einerseits die Funktion der niederohmigen Stromleitung und andererseits die Wärmespreizung und Wärmeabfuhr zur effektiven Kühlung des Leistungshalbleiterbauelementes.

Derartige Leistungshalbleiterbauelemente verfügen häufig nur über einen einzigen Leistungs-Ausgangsanschluss, über den der Leistungsstrom zum Betreiben der Last nach außen geführt wird. Dieser Ausgangsanschluss ist elektrisch und mechanisch über eine einzige Lötverbindung mit der auf der Leiterplatte angeordneten Kontaktfläche verbunden. Nachdem diese Lötverbindung einen relativ geringen Querschnitt aufweist, wird an dieser Engstelle, bedingt durch den sich dort ergebenden Widerstand, eine relativ hohe Verlustleistung erzeugt, welche letztlich sowohl den Ausgangsanschluss als auch die Lötverbindung mehr oder weniger stark erwärmt. Je höher der von dem Leistungshalbleiterbauelement zum Schalten bzw. Betreiben der Last erzeugte Ausgangsstrom ist und/oder je geringer dieser effektive Querschnitt der Ausgangsanschlüsse ist, umso höher ist der Widerstand und die damit einhergehende verlustleistungsbedingte Erwärmung.

Aus diesem Grunde werden vor allem bei für hohe Ausgangsströme ausgelegte Leistungshalbleiterbauelementen mehrere Ausgangsanschlüsse verwendet, um damit den effektiven Querschnitt für den Ausgangsstrom zu erhöhen und damit den Ausgangsanschluss - bedingten Widerstand zu reduzieren. Dadurch ist die Montage auf einem Stanzgitter aber schwieriger:
Ein Aspekt bei der Montage besteht darin, die mit mehreren Ausgangsanschlüssen versehenen Leistungshalbleiterbauelemente gezielt auf den dafür zur Verfügung stehenden Kontaktanschlüssen zu platzieren. Während dies bei lediglich einem Ausgangsanschluss und einem Steueranschluss noch relativ einfach ist, gestaltet sich dies bei einer Vielzahl von Ausgangs- und Steueranschlüssen zunehmend schwieriger, insbesondere, wenn die Ausgangsanschlüsse und der Steueranschluss unmittelbar nebeneinander angeordnet sind und die jeweilige Kontaktfläche und der Abstand zwischen Ausgangs- und Steueranschluss relativ klein ist.

Ein weiterer Aspekt besteht darin, dass zum Kontaktieren der Mehrzahl an Ausgangsanschlüssen auch eine größere Menge an Lötmaterial auf der Kontaktfläche erforderlich ist. Dadurch besteht die zusätzliche Gefahr, dass Lötmaterial von der Kontaktfläche für die Ausgangsanschlüsse auf die Kontaktfläche für den Steueranschluss übertritt, insbesondere wenn die beiden Kontaktflächen sehr eng beieinander angeordnet sind. Durch das Zusammenfließen wird ein unerwünschter Kurzschluss zwischen den Kontaktanschlüssen erzeugt, wodurch das Leistungshalbleiterbauelement funktionsunfähig werden wird.

Das Dokument WO 90/04912 zeigt ein SMD-Bauteil, welches auf einer Leiterplatte mittels eines Formteils in einfacher Art und Weise positioniert wird.

### ZUSAMMENFASSUNG DER ERFINDUNG

Vor diesem Hintergrund liegt der vorliegenden Erfindung die Aufgabe zugrunde, ein einfacher auf einer Leiterplatte montierbares Leistungshalbleiterbaulement anzugeben. Erfindungsgemäß wird diese Aufgabe durch eine Leiterplattenanordnung mit den Merkmalen des Patentanspruchs 1 und/oder durch eine Steuervorrichtung mit den Merkmalen des Patentanspruches 14 gelöst und/oder durch ein Verfahren mit den Merkmalen des Patentanspruches 15 gelöst.

Demgemäß ist eine Leiterplattenanordnung vorgesehen, mit einer Leiterplatte, welche einen ersten und einen davon galvanisch getrennten zweiten Lötbereich aufweist und welche ferner einen zwischen den Lötbereichen angeordneten und sich von den Lötbereichen abhebenden Trennsteg aufweist, mit einem Leistungshalbleiterbauelement, welches ein Gehäuse mit einer Ausgangsanschlussseite aufweist, aus der zumindest ein Steueranschluss und eine Vielzahl von Ausgangsanschlüssen herausragen, welche im Wesentlichen nebeneinander an der Ausgangsanschlussseite angeordnet sind, wobei der Steueranschluss elektrisch und mechanisch mit dem ersten Lötbereich und die Ausgangsanschlüsse elektrisch und mechanisch mit dem zweiten Lötbereich verbunden sind und der Steueranschluss von den Ausgangsanschlüssen über den abgehobenen Trennsteg getrennt ist.

Elektrisch bedeutet in diesem Zusammenhang, dass zwischen dem jeweiligen Anschluss und Lötbereich ein elektrischer Kontakt vorhanden ist. Mechanisch bedeutet in diesem Zusammenhang, dass zwischen dem jeweiligen Anschluss und Lötbereich ein Lötkontakt vorhanden ist.

Der erste Lötbereich bildet dabei einen Steueranschluss, über den Steuersignale in das Leistungshalbleiterbauelement eingekoppelt werden können. Der zweite Lötbereich bildet einen Ausgangsanschluss, über welchen eine mit dem Leistungshalbleiterbauelement verbundene und von diesem betriebene Last, beispielsweise ein Elektromotor, ein Kühlerlüftermotor, eine Gleichrichterschaltung, Wechselrichterschaltung und dergleichen, betrieben werden.

Die der vorliegenden Erfindung zugrunde liegende Idee besteht darin, zwischen den für die Steueranschlüsse und Ausgangsanschlüsse der Leistungshalbleiterbauelemente vorgesehenen Lötbereichen einen eigens dafür vorgesehenen Trennsteg vorzusehen. Dieser Trennsteg hebt sich von den jeweiligen Oberflächen der Lötbereiche derart ab, dass er als Fließbarriere fungiert und damit verhindert, dass das auf dem ersten bzw. zweiten Lötbereich aufgebrachte Lötmaterial in Kontakt mit dem jeweils anderen Lötbereich kommen kann. Auf diese Weise wird mittels der Trennstege ein Zusammenfließen der über die Trennstege voneinander benachbarten Lötbereiche effektiv verhindert.

Im Allgemeinen gestaltet sich das Auflöten einer Vielzahl von nebeneinander angeordneten Ausgangsanschlüssen auf ein und derselben Lötfläche dann besonders aufwendig, wenn diese Ausgangsanschlüsse sehr eng beieinander angeordnet sind, die Lötflächen entsprechend klein ausgebildet sind und/oder der Abstand von Lötflächen sehr gering ist. Durch das Bereitstellen der Trennstege ist hier eine effektive Barriere gegeben, was insbesondere das Positionieren und Auflöten signifikant vereinfacht.

Dadurch, dass auf diese sehr einfache, jedoch nichtsdestotrotz sehr effektive Weise ein Zusammenfließen der Lötmasse zwischen erstem und zweitem Lötbereich verhindert wird, ergibt sich auch kein dadurch bedingter Kurzschluss zwischen dem Steueranschluss und den Ausgangsanschlüssen, was unmittelbar zu einem Funktionsausfall der entsprechenden Leistungshalbleiterbauelemente führen würde. Die dadurch bedingte Ausschussrate wird reduziert, wodurch auf Leiterplatten angeordnete Leistungshalbleiterbauelemente kostengünstiger hergestellt werden können.

Vorteilhafte Ausgestaltungen und Weiterbildungen ergeben sich aus den weiteren Unteransprüchen sowie aus der Beschreibung unter Bezugnahme auf die Figuren der Zeichnung.

Gemäß der Erfindung ist zumindest einer der Ausgangsschlüsse verkürzt ausgebildet. Dieser Ausgangsanschluss wird auch als Dummy-Ausgangsanschluss bezeichnet und ist, anders als die übrigen Ausgangsanschlüsse, sowohl elektrisch als auch mechanisch von dem zweiten Lötbereich entkoppelt. Die Verkürzung des Dummy-Ausgangsanschlusses kann auf verschiedene Art und Weise geschehen, beispielsweise bereits in der Herstellung des Leistungshalbleiterbauelementes. Besonders bevorzugt ist es aber, wenn der Dummy-Ausgangsanschluss abgebrochen, abgeschnitten, abgestanzt, abgetrennt, weggebogen oder dergleichen ausgebildet ist. Der Vorteil liegt hier darin, dass der Dummy-Ausgangsanschluss auch im Nachhinein, d.h. nach der Fertigung der Leistungshalbleiterbauelemente, erzeugt werden kann, sodass herkömmliche Leistungshalbleiterbauelemente mit nebeneinander angeordneten Ausgangsanschlüssen und Steueranschlüssen verwendbar sind und der Dummy-Ausgangsanschluss erst nachträglich durch Verkürzung umfunktioniert wird.

Gemäß der Erfindung sind der oder die Dummy-Ausgangsanschlüsse benachbart zu den Steueranschlüssen angeordnet. In montiertem Zustand befindet sich der Dummy-Ausgangsanschluss im Bereich des Trennsteges. Typischerweise ist lediglich ein einziger gemeinsam genutzter Steueranschluss vorgesehen, der zudem an einer äußeren Seite der Reihe an Ausgangsanschlüssen angeordnet ist. In diesem Falle bildet der oder die Dummy-Ausgangsanschlüsse gewissermaßen die Trennung zwischen Steueranschlüssen und den übrigen Ausgangsanschlüssen.

In einer bevorzugten Ausgestaltung weisen der sich von einer Oberfläche der Lötbereiche abhebende Trennsteg eine solche Breite auf, die zumindest der Breite des oder der verkürzt ausgebildeten Dummy-Ausgangsanschlüsse entspricht. Auf diese Weise ist es möglich, dass in montiertem Zustand, bei denen die Steueranschlüsse und die übrigen Ausgangsanschlüsse auf den entsprechenden Lötbereichen verlötet sind, in vertikaler Richtung von den Trennstegen beabstandet sind. Der Trennsteg definiert somit einen Raum zwischen diesen Steueranschlüssen und Ausgangsanschlüssen. Typischerweise weist der Trennsteg eine Breite im Bereich von 0,1 mm bis 2 mm, vorzugsweise eine Breite entsprechend der Stanzgitterstärke, also 0,5 mm bis 1,0 mm.

In einer zusätzlichen oder alternativen Ausgestaltung weist der Trennsteg eine Höhe auf, die zumindest derart hoch gewählt ist, dass eine auf zumindest einem der Lotbereiche aufgebrachte Lötmasse im viskosen Zustand nicht auf den jeweils anderen Lötbereich fließen kann. Die gewählte Höhe des Trennsteges hängt insbesondere von der auf den Lötbereichen aufgebrachten Lotmenge und/oder von der im erhitzten Zustand vorhandenen Viskosität der Lötmasse ab. Vorzugsweise weist der Trennsteg eine Höhe im Bereich von 0,1 mm bis 2 mm, insbesondere eine Höhe im Bereich von 0,5 mm bis 0,8 mm auf.

In einer bevorzugten Ausgestaltung weist die Leiterplatte einen über einen weiteren Trennsteg von dem ersten und zweiten Lötbereich getrennten Auflagebereich auf. Dieser Auflagebereich dient der Auflage des Gehäuses oder des Kühlkörpers des Leistungshalbleiterbauelementes, welches dort typischerweise auch befestigt sind. Vorzugsweise dient dieser Auflagebereich auch als weiterer Kontaktanschluss, welcher beispielsweise als Anschluss für ein Bezugspotenzial des Leistungshalbleiterbauelementes dient.

In einer Weiterbildung ist an einer Unterseite des Gehäuses eine großflächige Kühlschicht angeordnet, die beispielsweise als flächige, über die gesamte Unterseite sich erstreckende Schicht oder Platte ausgebildet sein kann. Diese Kühlschicht ist thermisch mit dem oder den im Gehäuse vorhandenen Bauelementen gekoppelt. Diese Kühlschicht, welche elektrisch und/oder mechanisch auf dem Auflagebereich befestigt ist, hat die Aufgabe, von den innerhalb des Gehäuses vorhandenen Bauelementen im Betrieb erzeugte Wärme nach außen abzugeben. Je nach Leistungsklasse der im Gehäuse angeordneten Bauelemente, d.h. je nachdem, welcher Strom von diesen Bauelementen geschaltet wird, wird eine entsprechend hohe Leistung geschaltet, wodurch eine Verlustwärme erzeugt wird. Diese Verlustwärme wird von den Bauelementen über die Kühlschicht nach außen abgeleitet, um die Funktionsweise des Leistungshalbleiterbauelementes sicherzustellen. Vorzugsweise ist diese Kühlschicht mit einem auf der Leiterplatte aufgebrachten oder in der Leiterplatte vorhandenen Wäremeleitmaterial gekoppelt, welches die effektive Weiterleitung der Wärme ermöglicht.

In einer weiteren, besonders bevorzugten Ausgestaltung weist die Leiterplatte ein elektrisch leitfähiges Stanzgitter auf, welches die ersten und zweiten Lötbereiche umfasst. Bei Kontaktierung der ersten und zweiten Lötbereiche des Stanzgitters durch die entsprechenden Steueranschlüsse bzw. Ausgangsanschlüsse wird damit eine niederohmige Verbindung ermöglicht. Wesentlich ist, dass die ersten und zweiten Lötbereiche des Stanzgitters voneinander elektrisch getrennt sind. Besonders bevorzugt ist es, wenn auch der Auflagebereich Bestandteil des Stanzgitters ist. In diesem Falle bildet das Stanzgitter gewissermaßen selbst den Kühlkörper zur Kühlung des darauf befestigten Leistungshalbleiterbauelementes. Zudem kann vorgesehen sein, dass dieser Auflagebereich einen dritten Kontaktanschluss bildet, der beispielsweise mit einem Bezugspotenzial, beispielsweise der Bezugsmasse, gekoppelt ist. Das Stanzgitter ist vorzugsweise zumindest teilweise aus hochleitfähigem Metall, welches somit eine sehr hohe thermische Leitfähigkeit sowie eine sehr hohe elektrische Leitfähigkeit aufweist.

Vorzugsweise kann die Kühlschicht neben ihrer Funktion der thermischen Wärmeableitung auch die Funktion eines elektrischen Kontaktanschlusses haben, sofern sie elektrisch leitfähig ist. Besonders bevorzugt ist es, wenn die beispielsweise an einer Unterseite des Gehäuses vorgesehene Kühlschicht den dritten Kontaktanschluss (z.B. Drain) des Leistungshalbleiterbauelementes, der beispielsweise mit einem Bezugspotenzial beaufschlagt ist, bildet.

In einer ebenfalls bevorzugten Ausgestaltung werden die Trennstege durch Umspritzen des Stanzgitters mit einem elektrisch isolierenden Material, insbesondere Kunststoff, hergestellt. Das Umspritzen des Stanzgitters erfolgt unter Verwendung eines elektrisch isolierenden, temperaturfesten Thermoplast, insbesondere PPS (Polyethylensulfid). Besonders bevorzugt ist es, wenn das gesamte Stanzgitter, mit Ausnahme der Lötbereiche, Auflagebereiche, entsprechenden Verbindungsleitungen und dergleichen, mit Kunststoff umspritzt werden, um auf diese Weise die Leiterplatte zu erzeugen.

In einer bevorzugten Ausgestaltung sind die Lötbereiche bezüglich ihrer Länge und Breite, mithin also ihrer Lötfläche, derart dimensioniert, dass der Steueranschluss mit dessen Auflageflächen auf den ersten Lötbereich und die Ausgangsanschlüsse mit dessen Auflageflächen auf den zweiten Lötbereich auflegbar und dort befestigbar sind. Die Auflageflächen bezeichnen diejenigen Bereiche der Steueranschlüsse bzw. Ausgangsanschlüsse, mit welchen diese in montiertem Zustand mechanisch in Kontakt mit den jeweiligen Lötbereichen kommen. Die ersten und zweiten Lötbereiche sind also bezüglich deren Auflageflächen derart dimensioniert, dass sie zumindest größer sind als eine Fläche, die sich durch Projektion der Auflageflächen der Steueranschlüsse bzw. Ausgangsanschlüsse ergibt. Damit ist stets gewährleistet, dass sämtliche Steueranschlüsse bzw. Ausgangsanschlüsse zum Zwecke der Herstellung einer Lötverbindung an die für sie vorgesehenen Lötbereiche positionierbar sind.

In einer typischen Ausgestaltung ist als Gehäusetyp ein SMD-Gehäuse zur Oberflächenmontage des Leistungshalbleiterbauelementes vorgesehen. Dieses flach ausgebildete SMD-Gehäuse weist vier Außenseiten auf, von denen lediglich eine die Ausgangsanschlussseite bildet. An dieser Ausgangsanschlussseite ragen die die Steueranschlüsse und Ausgangsanschlüsse bildenden Anschlussbeine zur Auflage auf die Lötbereiche heraus. Das SMD-Gehäuse kann z.B. als T0262-Gehäuse oder 7-Pin T0263-Gehäuse ausgebildet sein. Beispielsweise ragen bei einem als 7-Pin T0263-Gehäuse ausgebildeten Leistungshalbleiterbauelement insgesamt sechs oder sieben Anschlussbeine an der Ausgangsanschlussseite heraus, von denen ein Anschlussbein den Steueranschluss bildet und die übrigen Anschlussbeine die Ausgangsanschlüsse bilden. Durch Ab-brechen oder Heraustrennen einer dieser Ausgangsanschlüsse kann auf sehr einfache Weise der Dummy-Ausgangsanschluss erzeugt werden.

Ein Leistungshalbleiterbauelement weist typischerweise ein oder mehrere im Gehäuse vorgesehene Bauelemente auf. In einer besonders bevorzugten Ausgestaltung ist das Leistungshalbleiterbauelement als Leistungsschalter ausgebildet, welcher insbesondere als Leistungs-MOSFET, IGBT, Thyristor, TRIAC ausgebildete Bauelemente enthält. Derartige Leistungsschalter sind zum Schalten hoher Ströme und Spannungen, mithin also zum Schalten hoher Leistungen ausgebildet. Vor allem Leistungs-MOSFET- und IGBT-Bauelemente sind aufgrund ihrer Halbleiterstruktur geeignet, hohe Leistungen bei hohen Taktfrequenzen zu schalten.

In einer besonders bevorzugten Ausgestaltung sind in dem Gehäuse mehrere Bauelemente vorgesehen, welche steuerseitig jeweils über den gemeinsamen Steueranschluss gleichzeitig ansteuerbar sind. Diese Bauelemente, welche beispielsweise als Leistungsschalter ausgebildet sein können, weisen jeweils einen Lastausgang auf, die zur Erzeugung eines hohen Ausgangsstromes parallel zueinander geschaltet sind. Der besondere Vorteil von derartigen, bezüglich deren Ausgänge parallel zueinander angeordneten Bauelementen besteht darin, dass für eine zu schaltende Leistung mehrere vergleichsweise leistungsschwächere Leistungsschalter vorgesehen sein können, die durch Parallelschalten eine höhere Leistung schalten können. Dies ist in thermischer Hinsicht vorteilhaft, da die einzelnen Leistungsschalter auf diese Weise nicht zu stark erhitzen. Zudem können auf diese Weise Leistungsschalter geringerer Leistungsklasse eingesetzt werden, die typischerweise kostengünstiger sind als ein einziger oder wenige leistungsstärkere Leistungsschalter. Besonders bevorzugt ist es, wenn eine der Anzahl der Ausgangsanschlüsse entsprechende Anzahl an Leistungsschalter bzw. Bauelemente verwendet wird. In diesem Falle könnte jeder Leistungsschalter bzw. jedes Bauelement mit seinem Lastausgang mit einem eigenen Ausgangsanschluss verbunden ist. Denkbar wäre allerdings auch, wenn die Lastausgänge der verschiedenen Bauelemente bzw. Leistungsschalter noch innerhalb des Gehäuses zusammengeführt werden und anschließend mit den verschiedenen Ausgangsanschlüssen gekoppelt werden. Dies hätte den Vorteil, dass im Nachhinein auf einfache Weise ein beliebiger Ausgangsanschluss herausgetrennt werden kann, ohne dass dadurch die Funktionsfähigkeit der verschiedenen Leistungsschalter bzw. Bauelemente beeinträchtigt wäre.

In einer ebenfalls bevorzugten Ausgestaltung ist ein einziger Steueranschluss vorgesehen. Dieser einzige Steueranschluss ist vorzugsweise an einer Außenseite der nebeneinander angeordneten Anschlussbeine bestehend aus Steueranschlüssen und Ausgangsanschlüssen angeordnet. Somit muss auf diese Weise lediglich minimal ein Dummy-Ausgangsanschluss bereitgestellt werden, um den Steueranschluss von den übrigen Ausgangsanschlüssen zu trennen.

In einer besonders bevorzugten Ausgestaltung des erfindungsgemäßen Verfahrens wird vor dem Anlöten des Steueranschlusses bzw. der Ausgangsanschlüsse ein entsprechendes Lötmaterial auf den ersten und zweiten Lötbereich aufgebracht. Auf diese Weise ist ein Wiederaufschmelzlöten möglich. Der Begriff Wiederaufschmelzlöten, der häufig auch als Reflow-Löten bezeichnet wird, bezeichnet ein in der Elektrotechnik gängiges Weichlötverfahren zum Löten von SMD-Bauteilen. Dabei wird in einem ersten Schritt ein Weichlot in Form einer Lotpaste vor der Bestückung auf die Leiterplatte aufgetragen, beispielsweise mittels Schablonendruck, Dispenser, durch Lotformteile oder auch galvanisch. In einem nächsten Schritt werden dann die Leistungshalbleiterbauelemente auf die Leiterplatte positioniert. Die Verwendung der Lotpaste hat den Vorteil, dass diese gewissermaßen klebrig ist und so die Bauteile bei der Bestückung direkt an der Paste hält. Sie müssen also nicht eigens fixiert oder aufgeklebt werden. In einem dritten Schritt erfolgt das Aufschmelzen des verbleibenden Lotes, um eine feste, stoffschlüssige Verbindung der Bauelemente mit der Leiterplatte zu erreichen. Bei diesem Aufschmelzen zentrieren sich die bestückten Bauteile durch die Oberflächenspannung auf den Lötbereichen selbst und setzen sich ab.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung. Insbesondere wird dabei der Fachmann auch Einzelaspekte als Verbesserungen oder Ergänzungen zu der jeweiligen Grundform der vorliegenden Erfindung hinzufügen.

### INHALTSANGABE DER ZEICHNUNG

Die vorliegende Erfindung wird nachfolgend anhand der in den schematischen Figuren der Zeichnungen angegebenen Ausführungsbeispiele näher erläutert. Es zeigen dabei:
- Fig. 1: eine perspektivische Ansicht eines Leistungshalbleiterbauelementes;
- Fig. 2: einen Ausschnitt einer erfindungsgemäßen Leiterplatte mit ersten und zweiten Lötbereichen;
- Fig. 3: eine erfindungsgemäße Leiterplattenanordnung, bei der das Halbleiterbauelement aus Fig. 1 auf der Leiterplatte aus Fig. 2 montiert ist;
- Fig. 4: ein zweites Ausführungsbeispiel einer erfindungsgemäßen Leiterplattenanordnung in der perspektivischen Ansicht;
- Fig. 5: ein zweites Ausführungsbeispiel einer erfindungsgemäßen Leiterplattenanordnung in einer seitlichen Querschnittsansicht.

Die beiliegenden Zeichnungen sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen.

Die Elemente der Zeichnungen sind nicht notwendigerweise maßstabsgetreu zueinander gezeigt.

In den Figuren der Zeichnung sind gleiche, funktionsgleiche und gleich wirkende Elemente, Merkmale und Komponenten - sofern nichts Anderes ausführt ist -jeweils mit denselben Bezugszeichen versehen.

### BESCHREIBUNG VON AUSFÜHRUNGSBEISPIELEN

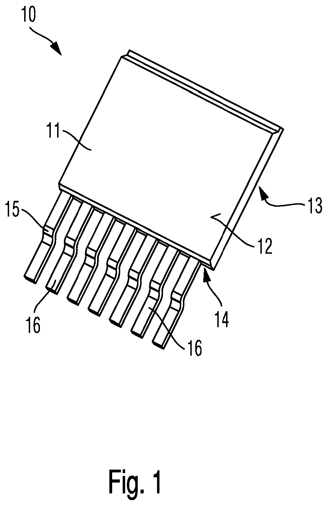

Fig. 1 zeigt eine perspektivische Ansicht eines Leistungshalbleiterbauelementes. Das Leistungshalbleiterbauelement ist hier mit Bezugszeichen 10 bezeichnet. Das Leistungshalbleiterbauelement 10 weist ein Gehäuse 11 auf, welches eine Oberseite 12 und eine gegenüber davon angeordnete Unterseite 13 (in Fig. 1 nicht sichtbar) aufweist. Ferner weist das Leistungshalbleiterbauelement 1 vier Außenseiten auf, von denen eine die Ausgangsanschlussseite 5 bildet. Bei dem in Fig. 1 dargestellten Leistungshalbleiterbauelement 1 handelt es sich um ein SMD-Bauelement, welches ein T0263-Gehäuse mit sechs Anschlussbeinchen 15, 16 an der Ausgangsanschlusseite 14 aufweist und ein Anschluss als Kühlfläche 13 ausgeführt ist. Dabei bildet eines dieser Anschlussbeinchen den Steueranschluss 15 und die übrigen Anschlussbeinchen bilden die Ausgangsanschlüsse 16.

Es sei angenommen, dass im Inneren des Leistungshalbleiterbauelementes 10 ein als MOSFET ausgebildeter Leistungsschalter vorgesehen ist, der somit einen Steueranschluss (Gate) sowie zwei Ausgänge (Drain, Source) aufweist. Es sei angenommen, dass der Steueranschluss 15 mit dem Gate-Anschluss des Leistungs-MOSFET 10 verbunden ist. Die Ausgangsanschlüsse 16 sind mit dem als Lastausgang fungierenden Source- oder Drain-Anschluss des Leistungs-MOSFET verbunden. Ferner sei angenommen, dass die Unterseite des Leistungs-MOSFET 10 eine großflächige, elektrisch leitfähige Kontaktfläche bildet, die im Inneren des Gehäuses 11 mit dem Source- oder Drain-Anschluss des Leistungs-MOSFET 10 verbunden ist.

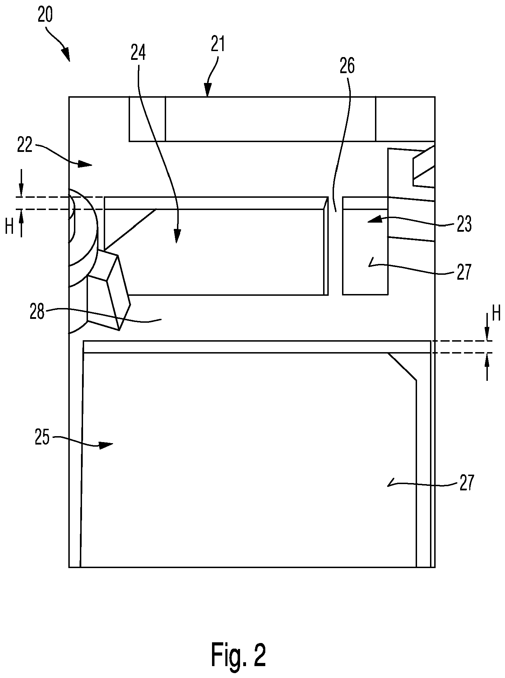

Fig. 2 zeigt einen Ausschnitt einer Leiterplatte, die hier mit Bezugszeichen 20 bezeichnet ist.

Die in Fig. 2 dargestellte Leiterplatte 20 umfasst ein Stanzgitter 21, welches teilweise mit einem Kunststoffmaterial 22 derart umspritzt ist, dass Bereiche des Stanzgitters 21 freiliegen. Das verwendete Kunststoffmaterial 22 ist vorzugsweise aus einem elektrisch nicht leitfähigen Material und aus einem thermisch wenig bzw. ebenfalls nicht leitfähigen Material. Das Kunststoffmaterial 22 ist beispielsweise ein Thermoplast, wie etwa PPS. Das Stanzgitter 21 ist vorzugsweise aus Kupfer, Aluminium oder aus einem herkömmlichen Blech mit thermisch und elektrisch leitfähiger Oberflächenbeschichtung.

Ein erster freiliegender Bereich des Stanzgitters 21 bildet einen ersten Lötbereich 23 und ein zweiter freiliegender Bereich des Stanzgitters 21 bildet einen zweiten Lötbereich 24. Ferner ist ein dritter Lötbereich 25 vorgesehen, der ebenfalls durch das Stanzgitter 21 gebildet wird. Die beiden Lötbereiche 23, 24 sind benachbart zueinander angeordnet und über einen Trennsteg 26 voneinander getrennt. Dieser Trennsteg 26 ist aus auf das Stanzgitter 21 aufgespritzten Kunststoff gebildet. Der Trennsteg hebt sich somit von einer durch das Stanzgitter 21 gebildeten Oberfläche 27 ab. Die beiden Lötbereiche 23, 24 sind darüber hinaus über einen weiteren Trennsteg 28 von dem Auflagebereich 25 beabstandet, wobei dieser Trennsteg 28 ebenfalls von der Oberfläche 27 abhebt. Mithin sind insbesondere sämtliche Lötbereiche 23, 24 sowie der Auflagebereich 25 vollständig von dem Kunststoffmaterial 22 umgeben, sodass die Lötbereiche 23, 24 und der dritte Lötbereich 25 wannenförmige Mulden bilden.

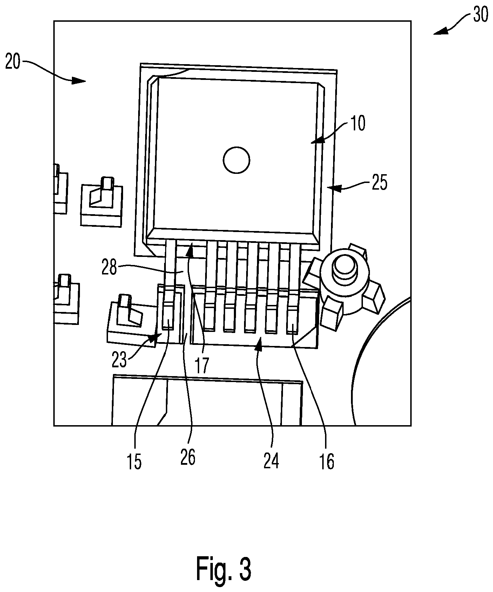

Fig. 3 zeigt eine erfindungsgemäße Leiterplattenanordnung, die hier mit Bezugszeichen 30 bezeichnet ist.

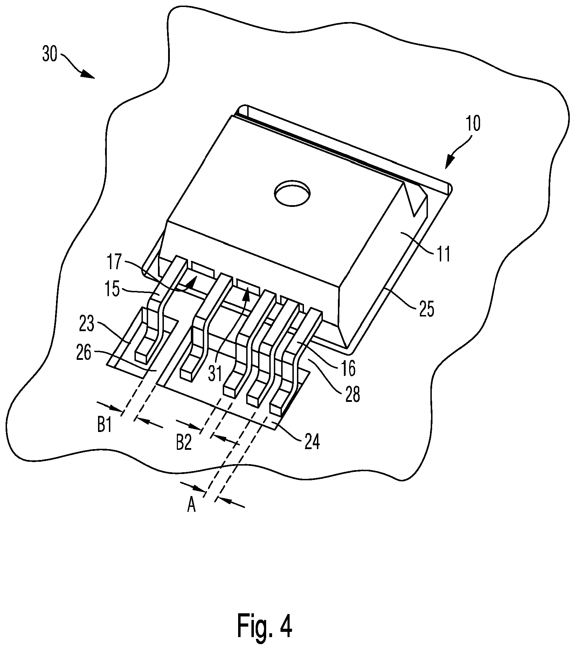

In dem Ausführungsbeispiel in Fig. 3 ist das Leistungshalbleiterbauelement 10 aus Fig. 1 auf der Leiterplatte 20 aus Fig. 2 befestigt und entsprechend elektrisch kontaktiert. Zu diesem Zwecke sind die Ausgangsanschlüsse 16 auf den zweiten Lötbereichen 24 positioniert und dort zum Zwecke der elektrischen Kontaktierung verlötet. Der Steueranschluss 15 ist auf den ersten Lötbereich 23 positioniert und dort zum Zwecke der elektrischen Kontaktierung dort verlötet. Im Lötbereich 25 ist die Unterseite des Gehäuses 11 des Leistungshalbleiterbauelementes 10 verlötet. Nachdem die Unterseite 13 den Kühlkörper 32 (siehe Fig. 4B) des Leistungshalbleiterbauelementes 10 bildet, über den das Leistungshalbleiterbauelement einerseits elektrisch kontaktiert werden soll und über den die im Inneren des Leistungshalbleiterbauelementes 10 erzeugte Wärme abgeführt werden soll, ist hier typischerweise eine sowohl elektrisch als auch thermisch gut leitfähige Kontaktverbindung vorgesehen, beispielsweise eine flächige Lötverbindung.

Erfindungsgemäß ist einer der Ausgangsanschlüsse 16 aus Fig. 1 verkürzt ausgebildet. Es handelt sich hier um einen herkömmlichen Ausgangsanschluss 16, der herausgeschnitten, abgestanzt, abgetrennt oder auf andere Weise verkürzt wurde. Dieser verkürzt ausgebildete Ausgangsanschluss bildet einen sogenannten Dummy-Ausgangsanschluss 17, dessen Funktion nachfolgend mit Bezug auf Fig. 3 noch erläutert wird.

Das Leistungshalbleiterbauelement 10 ist derart auf der Leiterplatte positioniert, dass dabei der Dummy-Ausgangsanschluss 17 im Bereich des Trennsteges 26 angeordnet ist, d.h. unmittelbar oberhalb des Trennsteges 26 positioniert ist. Dieser Dummy-Ausgangsanschluss 17 trägt somit nicht zur Stromleitung des Leistungshalbleiterbauelementes 10 hin zu dem zweiten Lötbereich 24 bei.

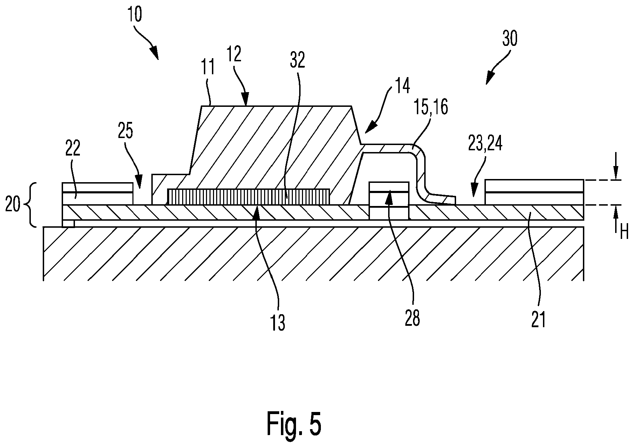

Fig. 4 und 5 zeigen ein zweites Ausführungsbeispiel einer erfindungsgemäßen Leiterplattenanordnung in der perspektivischen Ansicht (Fig. 4) und in einer seitlichen Querschnittsansicht (Fig. 5). Im Unterschied zu dem vorigen, anhand der Fig. 1 bis 3 dargestellten Ausführungsbeispielen ist in der Mitte der Ausgangsbeinchen 16, 17 zusätzlich ein weiterer Ausgangsanschluss 31 verkürzt ausgebildet. Der verkürzte Ausgangsanschluss 31 kann schon beim Standart-Bauelement vorgesehen sein, da zur Stromleitung auch der Lötbereich verwendet werden kann. Demzufolge kann der verkürzte Ausgangsanschluss standardmäßig abgetrennt ausgebildet sein, jedoch mit dem Lötbereich verbunden sein.

Die Trennstege 26, 28 dienen dem Zweck, dass beispielsweise die im ersten und zweiten Lötbereich 23, 24 aufgebrachte Lötmasse bei der Montage nicht in den jeweils anderen Lötbereich 23, 24 gelangen kann. Diese Gefahr könnte insbesondere bei einem Kontaktierprozess unter Verwendung des so genannten Reflow-Lötverfahrens entstehen, bei dem die Ausgangsanschlüsse 16 und der Steueranschluss 15 auf den Lötbereichen 23, 24 positioniert werden und durch Erhitzen die dort aufgebrachte Lötmasse viskos wird. Ohne die entsprechenden Trennstege 26, 28 könnte das viskos gewordene Lötmaterial in die entsprechend anderen Lötbereiche 23, 24 bzw. auch in den Auflagebereich 25 gelangen, was es allerdings zu vermeiden gilt. Aus diesem Grunde erheben sich die Trennstege 28, 26 von der Oberfläche 27 des Stanzgitters zumindest in einer Höhe H. Diese Höhe H ist vorzugsweise derart bemessen, dass in den Lötbereichen 23, 24 vorhandenes, durch Erhitzen viskoses Lötmaterial nicht in jeweils benachbarte Lötbereiche 23,24 bzw. Auflagenbereiche 25 gelangen kann.

Der Trennsteg 26 in Fig. 3 weist eine Breite B1 auf. Die Breite eines Anschlussbeinchens 15, 16 ist mit Bezugszeichen B2 bezeichnet. Ferner bezeichnet A den Abstand zwischen dem Steueranschluss 15 und dem diesen benachbarten Ausgangsanschluss 16. Die Breite B1 des Trennsteges 26 ist so bemessen, dass sie zumindest der Breite B2 des Dummy-Ausgangsanschlusses 17 und maximal dem Abstand A zwischen dem Steueranschluss 15 und dem diesem benachbarten Ausgangsanschluss 16 entspricht.

Obwohl die vorliegende Erfindung anhand bevorzugter Ausführungsbeispiele vorstehend vollständig beschrieben wurde, ist sie darauf nicht beschränkt, sondern auf vielfältige Art und Weise modifizierbar, sofern diese in den Umfang der Ansprüche fallen.

Die vorstehend beschriebenen Ausführungsbeispiele sind lediglich illustrativ zu verstehen sind, insbesondere im Hinblick auf die dort verwendeten Leiterplattentypen, Gehäusetypen, Leistungshalbleiterbauelemente, etc. Die Gehäusetypen und Leistungshalbleiterbauelemente können auch entsprechend anders ausgebildet sein, insbesondere was die Anzahl und Anordnung der Ausgangsanschlüsse und Steueranschlüsse angeht. Auch die angegebenen Dimensionierungen und Zahlenangaben sind lediglich des Verständnisses halber angegeben, sollen die Erfindung allerdings nicht dahingehend einschränken. Auch die angegebenen Materialien, insbesondere was das Lötmaterial, Kunststoffmaterial und Stanzgittermaterial angeht, sind als vorteilhafte Beispiele zu verstehen. Wenngleich in dem vorstehenden Ausführungsbeispiel das Leistungshalbleiterbauelement in einer bevorzugten Ausgestaltung als Leistungs-MOSFET ausgebildet ist, sei die Erfindung nicht dahingehend beschränkt, sondern lässt sich auch auf Leistungshalbleiterbauelemente mit anderen Bauelementen erweitern.

### Bezugszeichenliste

- 10: Leistungshalbleiterbauelement, Leistungs-MOSFET
- 11: Gehäuse
- 12: Oberseite des Gehäuses
- 13: Unterseite des Gehäuses
- 14: Ausgangsanschlussseite
- 15: Steueranschluss
- 16: Ausgangsanschlüsse
- 17: Dummy-Ausgangsanschluss
- 20: Leiterplatte
- 21: Stanzgitter
- 22: Kunststoffmaterial
- 23: erster Lötbereich
- 24: zweiter Lötbereich
- 25: Auflagebereich
- 26: Trennsteg
- 27: Oberfläche des Stanzgitters bzw. der Lötbereiche
- 28: Trennsteg
- 30: Leiterplattenanordnung
- 31: verkürzte Ausgangsanschluss
- 32: Kühlschicht

- A: Abstand
- B1: Breite des Trennsteges
- B2: Breite eines Ausgangsanschlusses
- H: Höhe des Trennsteges

## Patentansprüche

1. Leiterplattenanordnung (30),
mit einer Leiterplatte (20), welche einen ersten und einen davon galvanisch getrennten zweiten Lötbereich (23, 24) aufweist und welche ferner einen zwischen den Lötbereichen (23, 24) angeordneten und sich von den Lötbereichen (23, 24) abhebenden Trennsteg (26) aufweist,
mit einem Leistungshalbleiterbauelement (10), welches ein Gehäuse (11) mit einer Ausgangsanschlussseite (14) aufweist, aus der zumindest ein Steueranschluss (15) und eine Vielzahl von Ausgangsanschlüssen (16) herausragen, welche im Wesentlichen nebeneinander an der Ausgangsanschlussseite angeordnet sind, wobei der Steueranschluss (15) mit dem ersten Lötbereich (23) und die Ausgangsanschlüsse (16) mit dem zweiten Lötbereich (24) verbunden sind und wobei der Steueranschluss (15) von den Ausgangsanschlüssen (16) über den abgehobenen Trennsteg (26) getrennt ist, wobei zumindest ein Dummy-Ausgangsanschluss (17) vorgesehen ist, der gegenüber den Ausgangsanschlüssen (16) verkürzt ausgebildet ist und der von dem zweiten Lötbereich (24) entkoppelt ist, und wobei der Dummy-Ausgangsanschluss (17) benachbart zu dem Steueranschluss (15) und im Bereich des Trennstegs (26) angeordnet ist.

2. Anordnung nach Anspruch 1,
**dadurch gekennzeichnet,**
**dass** der Trennsteg (26) eine Breite (B1) aufweist, die zumindest einer Breite (B2) des verkürzten Dummy-Ausgangsanschlusses (17) entspricht, und/oder dass der Trennsteg (26) eine Höhe (H) aufweist, die zumindest derart hoch gewählt ist, dass eine auf die Lötbereiche (23, 24) aufgebrachte Lötmasse im viskosen Zustand nicht überschwappen kann.

3. Anordnung nach einem der vorstehenden Ansprüche,
**dadurch gekennzeichnet,**
**dass** die Leiterplatte (20) einen über einen weiteren Trennsteg (28) von dem ersten und zweiten Lötbereich (23, 24) getrennten Auflagebereich (25) aufweist.

4. Anordnung nach Anspruch 3,
**dadurch gekennzeichnet,**
**dass** an einer Unterseite (13) des Gehäuses (11) eine großflächige Kühlschicht (32) angeordnet ist, welche thermisch mit im Gehäuse (11) angeordneten Bauelementen gekoppelt ist und welche zudem elektrisch und/oder mechanisch auf dem Auflagebereich derart befestigt ist, um von den Bauelementen im Betrieb erzeugte Wärme abzuführen.

5. Anordnung nach einem der vorstehenden Ansprüche,
**dadurch gekennzeichnet,**
**dass** die Leiterplatte (20) ein Stanzgitter (21) aufweist und dass die ersten und zweiten Lötbereiche (23, 24) Bestandteil des Stanzgitters ist.

6. Anordnung nach Anspruch 5,
**dadurch gekennzeichnet,**
**dass** auch der Auflagebereich (25) Bestandteil des Stanzgitters ist.

7. Anordnung nach Anspruch 5 oder 6,
**dadurch gekennzeichnet,**
**dass** die Trennstege (26, 28) durch Umspritzen des Stanzgitters (21) mit einem Kunststoff hergestellt sind.

8. Anordnung nach einem der vorstehenden Ansprüche,
**dadurch gekennzeichnet,**
**dass** die Lötbereiche (23, 24) derart dimensioniert sind, dass der Steueranschluss (15) mit dessen Auflagefläche auf dem ersten Lötbereich (23) und die Ausgangsanschlüssen (16) mit deren Auflageflächen auf den zweiten Lötbereich (24) auflegbar und befestigbar sind.

9. Anordnung nach einem der vorstehenden Ansprüche,
**dadurch gekennzeichnet,**
**dass** als Gehäusetyp ein SMD-Gehäuse (11)zur Oberflächenmontage des Leistungshalbleiterbauelementes (10) vorgesehen ist.

10. Anordnung nach einem der vorstehenden Ansprüche,
**dadurch gekennzeichnet,**
**dass** das Leistungshalbleiterbauelement (10) als Bauelement zumindest einen Leistungsschalter aufweist.

11. Anordnung nach Anspruch 10,
**dadurch gekennzeichnet,**
**dass** der Leistungsschalter ein Leistungs-MOSFET, ein IGBT oder ein Thyristor ist.

12. Anordnung nach einem der vorstehenden Ansprüche,
**dadurch gekennzeichnet,**
**dass** in dem Gehäuse mehrere Bauelemente vorgesehen sind, welche steuerseitig jeweils über den gemeinsamen Steueranschluss (15) gleichzeitig ansteuerbar sind und welche bezüglich deren Lastausgänge parallel geschaltet sind.

13. Anordnung nach einem der vorstehenden Ansprüche,
**dadurch gekennzeichnet,**
**dass** ein einziger Steueranschluss (15) vorgesehen ist, welcher an einer Außenseite als Gehäuse (11) angeordnet ist.

14. Steuervorrichtung für ein Kühlerlüftermodul eines Kraftfahrzeuges, mit einer Leiterplattenanordnung (30) nach einem der vorhergehenden Ansprüche.

15. Verfahren zur Montage eines Leistungshalbleiterbauelementes (10) auf einer Leiterplatte (20) mit den Schritten:
Bereitstellen einer Leiterplatte (30), welche einen ersten und einen davon galvanisch getrennten zweiten Lötbereich (23, 24) aufweist, und eines Leistungshalbleiterbauelementes (10), welches ein Gehäuse (10) mit einer Ausgangsanschlussseite (14) aufweist, aus der zumindest ein Steueranschluss (15) und eine Vielzahl von im Wesentlichen nebeneinander angeordneten Ausgangsanschlüssen (16) herausragen;
Erzeugen eines sich von einer Oberfläche der Lötbereiche (23, 24) abhebenden Trennstegs (26) zwischen den beiden Lötbereichen (23, 24);
Erzeugung eines Dummy-Ausgangsanschlusses (17) durch Abtrennen eines dem Steueranschluss (15) benachbarten Ausgangsanschluss (16) ;
Positionieren des Leistungshalbleiterbauelementes (10) auf der Leiterplatte (20) derart, dass der Steueranschlusses (15) auf dem ersten Lötbereich (23) aufliegt, die Ausgangsanschlüsse (16) auf dem zweiten Lötbereich (24) aufliegt und der abgetrennte Dummy-Ausgangsanschluss (17) sich im Bereich des Trennsteg (26) befindet;
Anlöten des Steueranschlusses (15) auf den ersten Lötbereich (23) und der Ausgangsanschlüsse (16) auf den zweiten Lötbereich (24).

## Claims

1. Circuit board arrangement (30),
having a circuit board (20) that comprises a first soldering region (23) and a second soldering region (24) that is galvanically separated from said first soldering region and said circuit board further comprises a separator (26) that is arranged between the soldering regions (23, 24) and is raised from the soldering regions (23, 24),
having a power semiconductor component (10) that comprises a housing (11) having an output connector side (14) and at least one control connector (15) and a plurality of output connectors (16) protrude from said output connector side and said plurality of output connectors are arranged essentially adjacent to one another on the output connector side, wherein the control connector (15) is connected to the first soldering region (23) and the output connectors (16) are connected to the second soldering region (24) and wherein the control connector (15) is separated from the output connectors (16) via the raised separator (26), wherein at least one dummy output connector (17) is provided that is embodied as shortened with respect to the output connectors (16) and that is decoupled from the second soldering region (24), and wherein the dummy output connector (17) is arranged adjacent to the control connector (15) and in the region of the separator (26).

2. Arrangement according to Claim 1,
**characterised in that**
the separator (26) comprises a width (B1) that corresponds at least to a width (B2) of the shortened dummy output connector (17), and/or that the separator (26) comprises a height (H) that is selected so as to be at least tall enough for a soldering mass that is applied to the soldering regions (23, 24) in the viscous state not to overlap.

3. Arrangement according to one of the preceding claims,
**characterised in that**
the circuit board (20) comprises a resting region (25) that is separated from the first and second soldering region (23, 24) via a further separator (28).

4. Arrangement according to claim 3,
**characterised in that**
an extensive cooling layer (32) is arranged on an underside (13) of the housing (11) and said cooling layer is thermally coupled to components that are arranged in the housing (11) and said cooling layer is moreover electrically and/or mechanically fastened to the resting region in such a manner in order to dissipate heat that is generated by the components during operation.

5. Arrangement according to one of the preceding claims,
**characterised in that**
the circuit board (20) comprises a lead frame (21) and that the first and second soldering regions (23, 24) are an integral part of the lead frame.

6. Arrangement according to claim 5,
**characterised in that**
the resting region (25) is also an integral part of the lead frame.

7. Arrangement according to claim 5 or 6,
**characterised in that**
the separators (26, 28) are produced by means of over moulding the lead frame (21) with a synthetic material.

8. Arrangement according to one of the preceding claims,
**characterised in that**
the soldering regions (23, 24) are dimensioned in such a manner that the control connector (15) can be placed and can be fastened with the supporting surface of said control connector on the first soldering region (23) and the output connectors (16) can be placed and can be fastened with the supporting surfaces of said output connectors on the second soldering region (24).

9. Arrangement according to one of the preceding claims,
**characterised in that**
an SMD housing (11) is provided as a housing type for the surface mounting of the power semiconductor component (10).

10. Arrangement according to one of the preceding claims,
**characterised in that**
the power semiconductor component (10) comprises at least one circuit breaker as a component.

11. Arrangement according to claim 10,
**characterised in that**
the circuit breaker is a power MOSFET, an IGBT or a thyristor.

12. Arrangement according to one of the preceding claims,
**characterised in that**
multiple components are provided in the housing and said components can be controlled simultaneously on the control side in each case via the common control connector (15) and said components are connected in parallel in relation to their load outputs.

13. Arrangement according to one of the preceding claims,
**characterised in that**
a single control connector (15) is provided that is arranged on an outer side as a housing (11).

14. Control apparatus for a cooling fan module of a motor vehicle, said control apparatus having a circuit board arrangement (30) according to one of the preceding claims.

15. Method for mounting a power semiconductor component (10) on a circuit board (20) having the steps:
providing a circuit board (30) that comprises a first soldering region (23) and a second soldering region (24) that is galvanically separated from said first soldering region, and a power semiconductor component (10) that comprises a housing (10) having an output connector side (14) and at least one control connector (15) and a plurality of output connectors (16) that are arranged essentially adjacent to one another protrude from said output connector side;
producing a separator (26) between the two soldering regions (23, 24) and said separator is raised from a surface of the soldering regions (23, 24);
producing a dummy output connection (17) by means of severing an output connector (16) that is adjacent to the control connector (15);
positioning the power semiconductor component (10) on the circuit board (20) in such a manner that the control connector (15) rests on the first soldering region (23), the output connectors (16) rests on the second soldering region (24) and the severed dummy output connection (17) is located in the region of the separator (26);
soldering the control connector (15) to the first soldering region (23) and the output connectors (16) to the second soldering region (24).

## Revendications

1. Ensemble de circuit imprimé (30),
comportant un circuit imprimé (20) qui est pourvu d'une première zone de brasage et d'une deuxième zone brasage (23, 24) lesquelles sont galvaniquement séparées l'une de l'autre et qui est en outre pourvu d'un séparateur (26) lequel est disposé entre les zones de brasage (23, 24) et lequel fait saillie par rapport aux zones de brasage (23, 24),
comportant un composant semi-conducteur de puissance (10) qui est pourvu d'un boîtier (11) ayant un côté de connexion sortie (14) par lequel ressortent au moins une connexion de commande (15) et une pluralité de connexions de sortie (16) lesquelles sont sensiblement juxtaposées entre elles sur le côté de connexion sortie, la connexion de commande (15) étant reliée à la première zone de brasage (23) et les connexions de sortie (16) étant reliées à la deuxième zone de brasage (24), et la connexion de commande (15) étant séparée des connexions de sortie (16) par le séparateur (26) saillant, au moins une connexion de sortie factice (17) étant réalisée de manière à être raccourci par rapport aux connexions de sortie (16) et à être découplée de la deuxième zone de brasage (24), la connexion de sortie factice (17) étant disposée de manière à être adjacente à la connexion de commande (15) au niveau du séparateur (26).

2. Ensemble selon la revendication 1,
**caractérisé en ce**
**que** le séparateur (26) présente une largeur (B1) qui est supérieure ou égale à la largeur (B2) de la connexion de sortie factice (17) raccourcie et/ou que le séparateur (26) présente une hauteur (H) qui est choisie de manière à ce qu'il empêche tout débordement d'une masse de brasage que l'on applique, à l'état visqueux, sur l'une des zones de brasage (23, 24).

3. Ensemble selon l'une des revendications précédentes,
**caractérisé en ce**
**que** le circuit imprimé (20) comporte une zone de support (25) qui est séparée des première et deuxième zones de brasage (23, 24) par un autre séparateur (28).

4. Ensemble selon la revendication 3,
**caractérisé en ce**
**que** la face inférieure (13) du boîtier (11) est pourvue d'une couche de refroidissement (32) présentant une grande surface et étant couplée thermiquement à des composants disposés dans le boîtier (11), et étant en outre fixée électriquement et/ou mécaniquement sur ladite zone de support de manière à ce qu'elle évacue le chaleur que lesdits composants produisent lorsqu'ils sont en fonctionnement.

5. Ensemble selon l'une des revendications précédentes,
**caractérisé en ce**
**que** le circuit imprimé (20) comportant une grille de connexion réalisée par découpage (21) et que les première et deuxième zones de brasage (23, 24) font partie de ladite grille de connexion réalisée par découpage.

6. Ensemble selon la revendication 5,
**caractérisé en ce**
**que** la zone de support (25) fait également partie de ladite grille de connexion réalisée par découpage.

7. Ensemble selon les revendications 5 ou 6,
**caractérisé en ce**
**que** les séparateurs (26, 28) sont réalisées en appliquant, par projection, une matière plastique autour de la grille de connexion réalisée par découpage (21).

8. Ensemble selon l'une des revendications précédentes,
**caractérisé en ce**
**que** les zones de brasage (23, 24) sont dimensionnées de manière à ce que la connexion de commande (15) puisse être posée et fixée, au travers de sa face de support, sur la première zone de brasage (23) et les connexions de sortie (16) puissent être posées et fixées, au travers de leurs faces de support, sur la deuxième zone de brasage (24).

9. Ensemble selon l'une des revendications précédentes,
**caractérisé en ce**
**que** ledit boitier est du type boîtier CMS (11) afin de permettre un montage en surface du composant semi-conducteur de puissance (10).

10. Ensemble selon l'une des revendications précédentes,
**caractérisé en ce**
**que** le composant semi-conducteur (10) comporte, en tant que composant, au moins un disjoncteur à haute tension.

11. Ensemble selon la revendication 10,
**caractérisé en ce**
**que** ledit disjoncteur à haute tension est un MOSFET de puissance, un IHBT ou un thyristor.

12. Ensemble selon l'une des revendications précédentes,
**caractérisé en ce**
**que** plusieurs composants sont disposés au sein dudit boîtier et peuvent être commandés simultanément à travers la connexion de commande (15) commune située côté commande, tout en étant disposés à manière à ce que leurs sorties de charge soient connectées en parallèle.

13. Ensemble selon l'une des revendications précédentes,
**caractérisé en ce**
**qu'**il comporte une seule connexion de commande (15) qui est disposée sur une face extérieure sous forme de boîtier (11).

14. Dispositif de commande pour un module de ventilateur de radiateur d'un automobile, comportant un ensemble de circuit imprimé (30) selon l'une des revendications précédentes.

15. Procédé de montage d'un composant semi-conducteur de puissance (10) sur un circuit imprimé (20), comportant les étapes suivantes :
préparation d'un circuit imprimé (30) comportant une première et une deuxième zones de brasage (23, 24), lesquelles sont séparées galvaniquement l'une de l'autre, et d'un composant semi-conducteur de puissance (10) comportant un boîtier (10) ayant un côté connexion de sortie (14) par lequel ressortent au moins une connexion de commande (15) et une pluralité de connexions de sortie (16) lesquelles sont sensiblement juxtaposées entre elles ;
réalisation d'un séparateur (26) situé entre les deux zones de brasage (23, 24) lequel fait saillie par rapport à une surface des zones de brasage (23, 24) ;
réalisation d'une connexion de sortie factice (17) en déconnectant une connexion de sortie (16) qui est adjacente à la sortie de commande (15) ;
positionnement du composant semi-conducteur de puissance (10) sur le circuit imprimé (20), de manière à ce que la sortie de commande (15) vienne reposer sur la première zone de brasage (23), les connexions de sortie (16) viennent reposer sur la deuxième zone de brasage (24) et la connexion de sortie factice (17) déconnectée se trouve au niveau du séparateur (26) ;
fixation, par brasage, de la connexion de commande (15) sur la première zone de brasage (23) et des connexions de sortie (16) sur la deuxième zone de brasage (24).
